# EUROPEAN PATENT APPLICATION

(11) **EP 4 815 672 A1**
(43) Date of publication of application: **30.09.2026**
(21) Application number: 25223655.9
(22) Date of filing: 16.12.2025
(51) Int. Cl.: H10D 64/66, H10D 30/01, H10D 30/43, H10D 30/00, H10D 84/01, H10D 84/03, H10D 84/85, H10D 88/00

(54) **FIELD EFFECT TRANSISTOR THRESHOLD VOLTAGE TUNING THROUGH FLUORINE DOPING OF GATE STACK**

(30) Priority: 28.03.2025 US 202519094286
(71) Applicant: Intel Corporation, Santa Clara, CA 95054 (US)
(72) Inventor: AGRAWAL, Ashish, Hillsboro, 97124 (US); CHAKRABORTY, Wriddhi, Hillsboro, 97124 (US); BUDREVICH, Aaron, Portland, 97229 (US); CHEN, Yu-Hsuan, Hillsboro, 97124 (US); DEWEY, Gilbert, Beaverton, 97006 (US); BAUMGARTEL, Lukas, Portland, 97221-1308 (US)
(74) Representative: 2SPL Patentanwälte PartG mbB

(57) **Abstract**

Integrated circuitry comprising transistors having different transistor threshold voltages (Vₜ). In some examples, a gate electrode of the transistors with different Vₜ may include only one workfunction metal. Another metal, such as a fill metal, may be deposited over the workfunction metal and provide a solid-state source of fluorine that will subsequently diffuse toward the channel region(s), entering the workfunction metal. As diffused, different concentrations of fluorine may remain with workfunction metals of different transistors, thereby altering their threshold voltages. Different amounts of fluorine may be allowed to diffuse into different transistor structures to provide a range of Vₜ suitable for integrated circuit topologies of different performance/power metrics.

## Description

### BACKGROUND

For any transistor architecture, it is advantageous to be able to set the transistor threshold voltage (Vt). According to convention, Vₜ tuning may be accomplished through one or more of depositing a particular workfunction metal as part of a gate electrode, varying the thickness of one or more metal layers within a gate electrode, or providing gate insulators of different compositions, for example.

Demand for higher performance integrated circuits (ICs) in electronic device applications has motivated increasingly dense transistor architectures. Stacked gate-all-around (GAA) transistor structures, such as ribbon or wire (RoW) structures, include a plurality of channel regions that are in a vertical stack with one channel over another. For GAA transistor structures, and particularly for stacked RoW transistor architectures, the device geometry and/or small spaces between channel regions may limit gate insulator flexibility, and/or limit a workfunction metal layer to a thickness that is insufficient to strongly set Vₜ, and/or may preclude the use of multiple workfunction metals or metal layer thicknesses. Fabrication techniques and RoW transistor architectures that enable Vₜ tuning for even these aggressively scaled devices are therefore commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1A illustrates an isometric sectional view of a RoW transistor stack structure including gate electrodes with different fluorine content, in accordance with some embodiments;
FIG. 1B illustrates a graph of transistor threshold voltage as a function of fluorine content within a gate electrode, in accordance with some embodiments;
FIG. 2A illustrates a first cross-sectional view of the RoW transistor stack structure introduced in FIG. 1A, in accordance with some embodiments;
FIG. 2B illustrates a second cross-sectional view of the RoW transistor stack structure introduced in FIG. 1A, in accordance with some embodiments;
FIG. 3 illustrates an expanded cross-sectional view the RoW transistor stack structure introduced in FIG. 1A, in accordance with some embodiments;
FIG. 4 is a flow diagram illustrating methods of tuning Vₜ in a RoW transistor structures through the differentiation of fluorine content within a gate electrode stack, in accordance with some embodiments;
FIG. 5A illustrates a cross-sectional view of a RoW transistor stack structure evolving as blocks in the methods introduced in FIG. 4 are practiced, in accordance with some embodiments;
FIG. 5B illustrates a cross-sectional view of a RoW transistor stack structure evolving as blocks in the methods introduced in FIG. 4 are practiced, in accordance with some alternative embodiments;
FIG. 6 illustrates a mobile computing platform and a data server machine employing an IC including RoW transistor structures with fluorine-based threshold voltage tuning, in accordance with embodiments; and
FIG. 7 is a functional block diagram of an electronic computing device, in accordance with some embodiments.

### DETAILED DESCRIPTION

Embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause and effect relationship).

The terms "over," "under," "between," and "on" as used herein refer to a relative position of one component or material with respect to other components or materials where such physical relationships are noteworthy. For example in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

As described further below, fluorine may be introduced into a transistor gate stack and diffused toward a transistor channel region during an IC fabrication process as one means of controlling, setting or tuning a threshold voltage of the transistor. According to embodiments herein, integrated circuitry may comprise transistors having any number of different transistor threshold voltages (Vₜ) within a same IC die, chip, or chiplet. In some examples, a transistor gate electrode may include a workfunction metal and another metal, such as a fill or cap metal, that may be deposited over the workfunction metal. The fill or cap metal may be a source of fluorine that subsequently diffuses toward the channel region(s), entering the workfunction metal. As diffused, different concentrations of fluorine may remain with workfunction metal(s) of different transistors, thereby tuning their threshold voltage. Different amounts of fluorine may be allowed to diffuse into different transistor structures to provide a range of Vₜ suitable for integrated circuit topologies of different performance/power metrics. Fluorine-based threshold tuning may be implemented alone or in combination with other means of setting a transistor threshold voltage. For example, in addition to the incorporation of fluorine into a gate stack, one or more metallic compounds of a composition distinct from one employed as a high-k gate insulator may introduce a dipole species (e.g., as a silicate, or a hafnate) within a gate stack, thereby altering the dipole properties of the gate insulator material. In other examples, transistors within an IC may may include multiple (different) workfunction metals with a selective addition of fluorine modulating their workfunction to a different extent across the various transistor structures. In still other examples, fluorine doping of a gate stack may be combined with both metallic dipole doping and the use of multiple workfunction metals to arrive at menu of 5-10, or more, Vₜ levels.

Embodiments described herein may be implemented across transistors of a different conductivity type (i.e., P-type vs. N-type) or across transistors of a single conductivity type. Embodiments described herein may be implemented across transistors occupying different spatial areas, or footprints within an IC die. For example, a first transistor may have a gate stack with a first level of fluorine doping, while a second, adjacent transistor may have a gate stack with second level of fluorine doping. Alternatively, embodiments described herein may be implemented across transistors occupying different strata of channel regions within a stacked transistor structure. For example, a first transistor may have a gate stack with a first level of fluorine doping, while a second, overlying, transistor may have a gate stack with second level of fluorine doping. In some embodiments where a transistor stack is a CMOS stack structure that includes both P-type and N-type transistors, Vₜ for the complementary conductivity types may be differentiated, at least in part, by the presence of a fluorine species.

In the following description, examples are given in the context of a vertically stacked transistor structure, which in some embodiments is a CMOS stack structure. Nevertheless, the principles taught in the context of vertically scaled transistors may be readily applied to transistor architectures that not so aggressively scaled. For example, the transistors illustrated as vertically integrated may instead be integrated horizontally without deviating from the scope of the present disclosure.

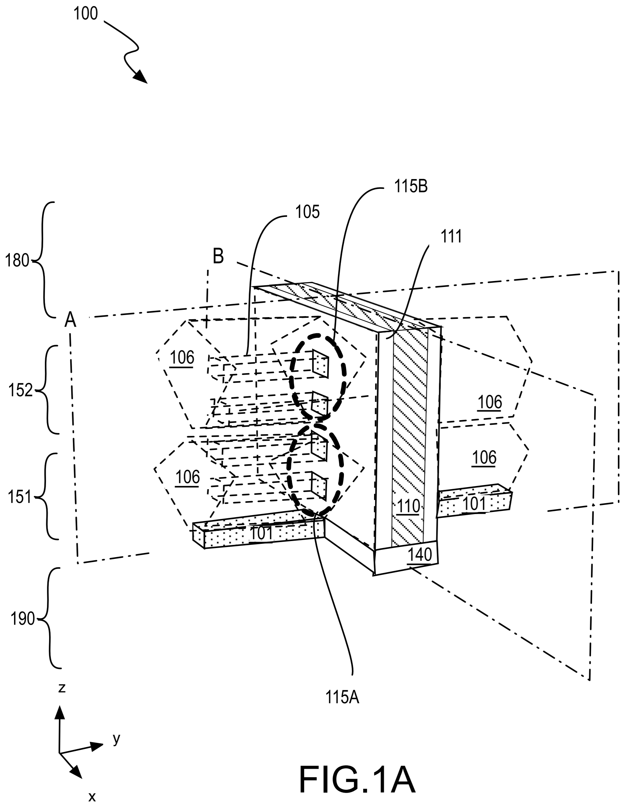

FIG. 1A illustrates an isometric sectional view of a RoW transistor stack structure 100 including selective fluorine incorporation within a gate stack, in accordance with some embodiments. RoW transistor stack structure 100 has a GAA transistor architecture with a plurality of stacked channel regions. RoW transistor stack structure 100 is illustrated as including four active channel regions, but a RoW transistor stack structure may include any integer number of channel regions (e.g., 2, 3, 4, 5...10...20, etc.) as embodiments herein are not limited in this respect.

RoW transistor stack structure 100 includes a transistor 152 overlying a transistor 151. In the illustrated example, transistor 151 comprises a plurality of RoW channel regions 115A (encircled by a first heavy dashed line), and transistor 152 includes a plurality of RoW channel regions 115B (encircled by a second heavy dashed line). Although two channel regions are illustrated for each of transistors 151 and 152, transistors within a stack structure may include any integer number of channel regions (e.g., 1, 2...5...10, etc.). Transistor 151 is distinguished from transistor 152 by at least a difference in threshold voltage (Vt). Transistors 151 and 152 may also have other compositional, structural and/or functional distinctions as embodiments herein are not limited in this respect.

In accordance with some embodiments, RoW transistor stack structure 100 is a CMOS RoW transistor stack where transistor 151 is of a first conductivity type, and transistor 152 is of a second, complementary, conductivity type. Transistors 151 and 152 may each be of either positive or negative conductivity type such that channel regions 115A or 115B may each be portions of either a P-type or N-type transistor. In some exemplary embodiments, channel regions 115A are portions of a P-type transistor while channel regions 115B are portions of an N-type transistor. In the illustrated example, source and drain regions 106 are coupled together through channel regions 115A and 115B. In such a CMOS transistor stack, each of channel regions 115A may be operable to contribute to a total drive current of (e.g., a PMOS) transistor 151. Each of channel regions 115B may be operable to contribute to a total drive current of (e.g., an NMOS) transistor 152.

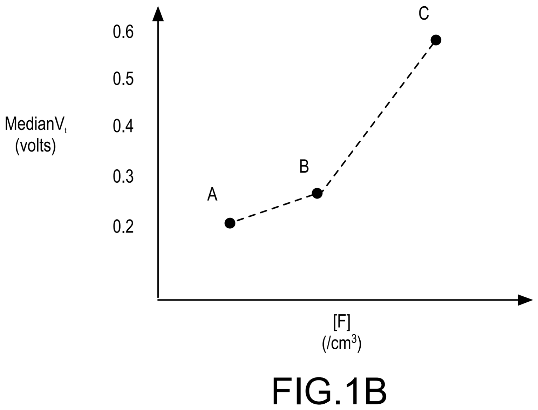

As shown in FIG. 1A, channel regions 115A, 115B may be over a substrate material 101, which may have been part of a workpiece substrate, such as a large format semiconductor wafer, for example. An integrated circuit including RoW transistor stack structure 100 may include any number of frontside metallization levels 180 over a "top" or "front" side of transistor structure 100, for example. Metallization levels 180 may have any known structure, and any number of levels interconnecting one or more transistor terminals with other nodes in a circuit. An integrated circuit including RoW transistor stack structure 100 may further include any number of backside metallization levels 190 under a "bottom" or "back" side of transistor structure 100, for example. Metallization levels 190 may also have any known structure, and any number of levels interconnecting one or more transistor terminals with other nodes in a circuit. However, structural aspects of substrate material 101 and metallization levels 180, 190 are not depicted in FIG 1 to avoid obscuring the view of RoW transistor stack structure 100. In reference to substrate material 101 and/or metallization levels 180 and 190, channel regions 115A may be referred to herein as "lower," channel regions while channel regions 115B may be referred to herein as "upper," channel regions.

In FIG. 1A, two orthogonal planes A and B are demarked by dashed line. Plane A is a "gate-cut" plane that passes through a transverse width of gate electrode 110 and passes through a longitudinal length of channel regions 115A, 115B. Plane B is a "fin-cut" plane that passes through a transverse width of channel regions 115A, 115B and passes through a longitudinal length of gate electrode 110. As further illustrated, source and drain regions 106 are electrically and physically coupled to opposite sides of channel regions 115A, 115B. In this example, source and drain regions 106 comprise faceted epitaxial material that has been grown, for example laterally from an end portion of channel regions 115A, 115B embedded with in a spacer dielectric material 111, and/or from cantilevered source/drain nanowire ends (e.g., 105) drawn in dashed line, and/or from substrate material 101. For CMOS RoW transistor stacks, source and drain regions 106 may comprise both P-type (e.g., lower) and N-type (upper) portions associated with each of transistors 151 and 152. For PMOS RoW transistor stacks where transistors 151 and 152 are both PMOS, source and drain regions 106 may be homogenously P-type. For NMOS RoW transistor stacks where transistors 151 and 152 are both NMOS, source and drain regions 106 may be homogenously N-type.

Source and drain regions 106 need not be epitaxial material, in which case the facets represented by dashed line in FIG. 1A may not be present. Source and drain regions 106 also need not be merged into a single unitary body, in which case cantilevered source/drain nanowire ends (e.g., 105) may be individually contacted by a terminal contact metal. Although not depicted for the sake of clarity, metallization levels 180 may include a source and/or drain contact metallization that is in contact with source and drain regions 106. Likewise, front-side metallization levels 180 may further include a contact (not depicted) to gate electrode 110.

Gate electrode 110 is between source and drain regions 106, with intervening spacer dielectric material 111 between gate electrode 110 and source and drain regions 106. RoW transistor stack structure 100 may further include one or more additional dielectric materials. In the illustrated example, there is a dielectric material 140 under gate electrode 110 where gate electrode 110 extends laterally beyond channel regions 115A, 115B. Other dielectric material 140 (not depicted) may surround source and drain regions 106, as well as gate electrode 110.

As described further below, fluorine species may be introduced into gate electrode 110 and surround at least one of channel regions 115A or 115B thereby modulating the transistor threshold voltage from what it would otherwise be in absence of the fluorine species. As further illustrated in FIG. 1B, increasing a gate stack's fluorine content has the effect of increasing an NMOS transistor's threshold voltage. In the graph, three different treatments (A, B, C) diffused increasing concentrations of fluorine into the workfunction metal of an NMOS transistor gate electrode indicating Vₜ can be tuned over a range of at least 0.4 volts. The selective incorporation of fluorine into a transistor gate stack should be applicable for both NMOS and PMOS transistors as increasing a gate stack's fluorine content will decrease a PMOS transistor's threshold voltage.

In further reference to FIG. 1A, more fluorine may, for example, be selectively introduced around N-type channel regions 115B than around P-type channel regions 115A. Fluorine may be present at a detectable level only around N-type channel regions 115B such that the threshold voltage of a transistor with channel regions 115B is a function of both the workfunction metal and the non-zero fluorine content. In contrast, in the absence of significant fluorine content the threshold voltage of a transistor with channel regions 115A may be primarily a function of the workfunction metal.

In some other embodiments, fluorine is present only around P-type channel regions 115A. The threshold voltage of transistors with channel regions 115B would then be primarily a function of the workfunction metal while the threshold voltage of transistors with the channel regions 115A would be a function of both the workfunction metal and fluorine content. In other embodiments, significant, but different, concentrations of fluorine surround each of channel regions 115A and channel regions 115B.

In some further embodiments, a same workfunction metal (e.g., a mid-bandgap metal) may be around both P-type channel regions 115A and N-type channel regions 115B with a difference in fluorine content proximal to P-type channel regions 115A and N-type channel regions 115B modulating the threshold voltage between PMOS transistor 151 and NMOS transistor 152.

In accordance with some other embodiments, RoW transistor stack structure 100 is a NMOS RoW transistor stack. For such embodiments, transistor 151 is a first NMOS transistor with a first Vₜ, for example dependent on the presence of a first significant fluorine concentration within the gate stack proximal to channel regions 115A, while transistor 152 is a second NMOS transistor with a second Vₜ, for example dependent on the presence of a second significant fluorine concentration (or an absence of any fluorine) within the gate stack proximal to channel regions 115B.

Alternatively, RoW transistor stack structure 100 may be an PMOS RoW transistor stack. For such embodiments, transistor 151 may be a first PMOS transistor with a first Vₜ, for example dependent on the presence or absence of a first significant fluorine concentration within the gate stack proximal to channel regions 115A, while transistor 152 a second PMOS transistor with a second Vₜ, for example dependent on the presence of a second significant fluorine concentration (or an absence of any fluorine) within the gate stack proximal to channel regions 115B.

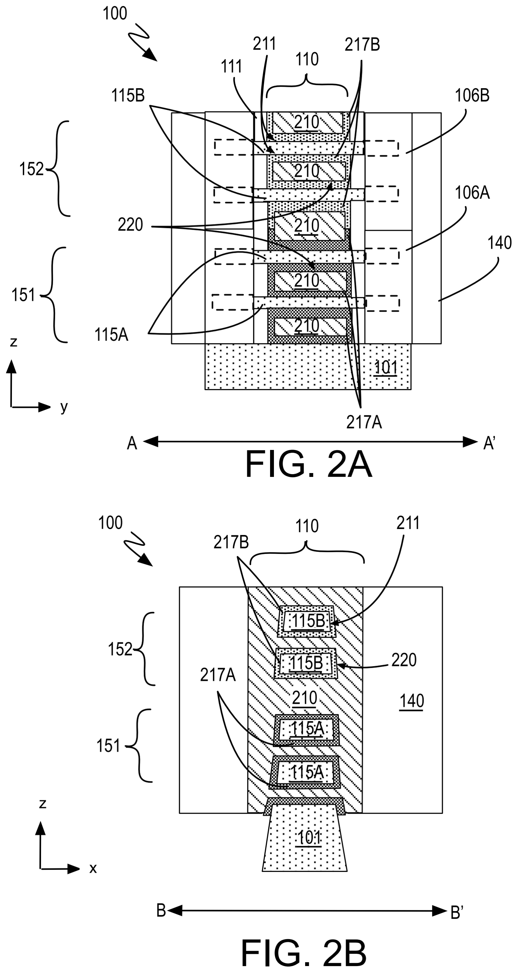

FIG. 2A illustrates a cross-sectional view of RoW transistor stack structure 100 along the A-A' plane introduced in FIG. 1A, in accordance with some embodiments. FIG. 2B illustrates a second cross-sectional view of RoW transistor stack structure 100 along the B-B' plane introduced in FIG. 1A, in accordance with some embodiments.

As shown in FIG. 2A, channel regions 115A, 115B have a longitudinal channel length (e.g., along y-axis) associated with a distance between source and drain regions 106. Channel regions 115A, 115B may extend through dielectric spacer 111, as illustrated. Channel regions 115A, 115B are bodies of semiconductor material that may have been patterned from a fin of a substrate material layer, for example. The trapezoidal profiles of channel regions 115A, 115B illustrated in FIG. 2B are representative of structural asymmetry associated with front-side transistor fabrication. Such asymmetry may be a result of feature sidewall slopes that evolve during subtractive patterning of a semiconductor fin, for example. Although channel regions 115A, 115B are illustrated in FIG. 2B as nanoribbons having a transverse width greater than their vertical thickness, channel regions 115A, 115B may instead be nanowires of substantially equal vertical thickness and lateral width.

In some embodiments, channel regions 115A, 115B are crystalline semiconductor. Although the crystalline semiconductor includes polycrystalline thin film material, the crystalline semiconductor may be advantageously substantially monocrystalline. In some such embodiments, the crystallinity of channel regions 115A, 115B is cubic with the top surfaces nearest to metallization levels 180 having crystallographic orientation of (100), (111), or (110), for example. Other crystallographic orientations are also possible. In some embodiments, channel regions 115A, 115B are a substantially monocrystalline group IV semiconductor material, such as, but not limited to substantially pure silicon (e.g., having only trace impurities), silicon alloys (e.g., SiGe), or substantially pure germanium (e.g., having only trace impurities). Channel regions 115A, 115B may also have any of these same exemplary compositions in alternative polycrystalline or amorphous embodiments, for example where RoW transistor stack structure 100 has been fabricated from a thin film semiconductor material layer. Polycrystalline or amorphous embodiments of channel regions 115A and 115B may also include semiconducting metal oxides, such as IGZO. Although channel regions 115A, 115B are illustrated as having a substantially homogenous composition, they may alternatively comprise one or more semiconductor heterojunctions that, for example further include a first semiconductor material adjacent to a second semiconductor material.

Source/drain regions 106 may similarly comprise any semiconductor material suitable for a transistor. In some embodiments, semiconductor material of source/drain regions 106 includes impurity-doped portions of semiconductor material protruding laterally beyond channel regions 115A, 115B as denoted by dashed lines in FIG. 2A. In the illustrated embodiment, source/drain regions 106 include a unified epitaxial semiconductor source/drain structure. Source/drain regions 106 may be comprise one or more electrically active impurities. In some embodiments, for example, source/drain regions 106 are a Group IV semiconductor material (e.g., Si, Ge, or SiGe alloy) with at least one of a p-type impurity (e.g., boron or gallium) or an n-type impurity (e.g., phosphorus, arsenic, or antimony). In exemplary CMOS RoW transistor stack structures, source/drain regions 106 include both a p-type portion (e.g., 106A) and an n-type portion (e.g., 106B).

As further illustrated in FIG. 2A and FIG. 2B, substrate material 101 is under the stack of channel regions 115A, 115B, under gate electrode 110, and may be a base of a fin, for example, from which channel regions 115A, 115B were formed. As such, substrate material 101 may have a composition and/or microstructure similar to channel regions 115A, 115B. For example, in some embodiments where channel regions 115A, 115B are of a Group IV material (e.g., silicon), sub-channel material 101 is also a Group IV material (e.g., silicon). In some further embodiments where channel regions 115A, 115B are substantially monocrystalline, sub-channel material 101 is also substantially monocrystalline, and has the same crystallinity and/or crystal orientation as that of channel regions 115A, 115B. In alternative embodiments, sub-channel material 101 is a buried insulator layer (e.g., SiO₂), for example of a semiconductor-on-insulator (SOI) substrate.

As further shown in FIG. 2A and FIG. 2B, RoW transistor stack structure 100 includes a gate stack comprising gate electrode 110 and a gate insulator 211 cladding channel regions 115A, 115B to provide gate-all-around control of channel conductivity. In the illustrated embodiment, the gate electrode 110 comprises a fill metal 210 over the workfunction metals 217A, 217B. Illustrated with different field shading, workfunction metals 217A and 217B have different compositions, varying at least to the extent that one has more fluorine content than the other. In some examples, the difference in fluorine concentration (cm⁻³) between workfunction metal 217 and workfunction metal 217B is at least one order of magnitude.

In some embodiments where gate electrode 110 includes only an n-type workfunction metal, for example having a workfunction between about 3.9 eV and about 4.2 eV, only fluorine content varies between workfunction metal 217A and workfunction metal 217B. This difference in fluorine concentration (cm⁻³) between workfunction metal 217A and workfunction metal 217B may be, for example, at least one order of magnitude. In other examples, only one of workfunction metal 217A or workfunction metal 217B has a detectable level of fluorine. Suitable n-type workfunction metals include, but are not limited to, hafnium, zirconium, titanium, tantalum, or aluminum-based metals. An n-type workfunction metal may be a metal carbide that include any of these elements (e.g., titanium carbide, zirconium carbide, tantalum carbide, hafnium carbide and aluminum carbide).

In some other embodiments where gate electrode 110 includes only a p-type workfunction metal, for example having a workfunction between about 4.9 eV and about 5.2 eV, only fluorine content varies between workfunction metal 217A and workfunction metal 217B. This difference in fluorine concentration (cm⁻³) between workfunction metal 217A and workfunction metal 217B may be, for example, at least one order of magnitude. In other examples, only one of workfunction metal 217A or workfunction metal 217B has a detectable level of fluorine. Suitable p-type materials include, but are not limited to, ruthenium, palladium, platinum, cobalt, nickel, molybdenum, titanium, tungsten, conductive metal nitrides (e.g., TiN, WN), and conductive metal oxides (e.g., ruthenium oxide).

In still other embodiments where gate electrode 110 instead includes only a mid-gap workfunction metal having a workfunction between those of the n-type and p-type workfunction metals (e.g., 4.2-4.9eV), only fluorine content varies between workfunction metal 217A and workfunction metal 217B. This difference in fluorine concentration (cm⁻³) between workfunction metal 217A and workfunction metal 217B may be, for example, at least one order of magnitude. In other examples, only one of workfunction metal 217A or workfunction metal 217B has a detectable level of fluorine. Such mid-gap workfunction metal embodiments may implement a CMOS transistor stack structure, for example, where fluorine doping of the gate electrode is relied upon to modulate threshold voltage between PMOS and NMOS transistors.

Gate electrode 110 may instead comprise multiple workfunction metals. For example, in an alternative CMOS RoW transistor stack structure gate electrode 110 may include any n-type workfunction metal described above in combination with any p-type workfunction metal described above, in which case the composition of workfunction metal 217A may differ from that of workfunction metal 217B both in fluorine content and in the type of metal(s) present. The difference in fluorine concentration (cm⁻³) between workfunction metal 217 and workfunction metal 217B may be, for example, at least one order of magnitude. In some examples, only one of workfunction metal 217A or workfunction metal 217B has a detectable level of fluorine.

Within a workfunction metal, fluorine may form metal fluoride compounds that are dependent upon the composition of the workfunction metal. For example, in aluminum-based workfunction metals, fluorine forms Al-F compounds. Mo-F, Ti-F or W-F compounds may be similarly formed when fluorine is introduced into alternative workfunction metals comprising Mo, Ti, or W.

As further illustrated in FIG. 2A and 2B, a compositionally distinct gate electrode fill metal 210 is over the workfunction metal 217A and/or 217B. In some embodiments, gate fill metal 210 also comprises fluorine and may be a source of fluorine that enters one or more of workfunction metals 217A, 217B as fluorine diffuses from gate electrode fill metal 210 toward channel regions 115A and/or 115B. In some embodiments where gate electrode fill metal 210 is W-based, fluorine is present in the form of W-F compounds. As further described below, diffusion of fluorine from gate electrode fill metal 210 into one or more of workfunction metals 217A, 217B may be controlled either through selectively varying the composition of fill metal 210 or by varying properties of an intervening barrier layer 220 located between fill metal 210 and workfunction metals 217A, 217B. As further described below, the film thickness of barrier layer 220 may be controlled to limit the diffusion of fluorine into at least one of workfunction metal 217A or 217B and thereby modulate one transistor's threshold voltage relative to another.

As further illustrated in FIG. 2A and 2B, transistor stack structure 100 includes a gate insulator 211 completely surrounding channel regions 115A, 115B. Gate insulator 211 is between workfunction metal 217A, 217B and channel regions 115A and 115B, respectively. In accordance with some exemplary embodiments, gate insulators 211 includes a high-k material (with a bulk relative permittivity of at least 9). This high-k material may advantageously have substantially the same chemical composition for both transistors 151 and 152. In other embodiments, gate insulator 211 differs in composition between transistor 151 and transistor 152, for example by an amount of a dipole Vₜ shifter present. A dipole Vₜ shifter may be, for example, one or more metallic compounds that further include a supplemental metal that is distinct from any other metal that may be present in the high-k material included in gate insulator 211.

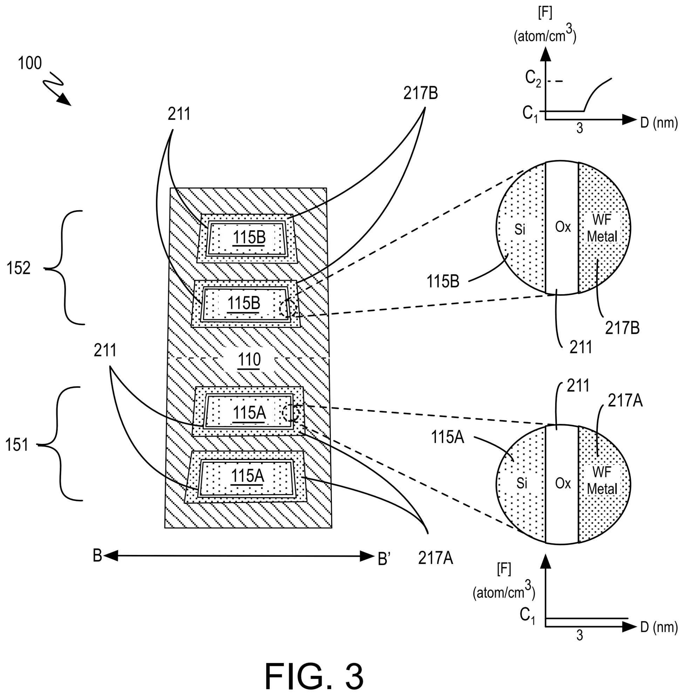

FIG. 3 illustrates an expanded cross-sectional view RoW transistor stack structure 100, in accordance with some embodiments. In some examples, gate insulator 211 includes a high-k material surrounding a native, or chemical, oxide material that is in direct contact with channel region 115A, 115B. For exemplary embodiments where channel region 115A, 115B comprises silicon (e.g., pure Si or an alloy), the chemical oxide material includes both Si and oxygen (e.g., SiOₓ) and is advantageously less than 1.5 nm in thickness. Elements other than silicon may be present within the chemical oxide material for other channel compositions. For example, Ge may be present within the chemical oxide material for embodiments where the channel region comprises predominantly Ge.

Gate insulator 211 includes a high-k material, for example, that is in direct contact with the chemical oxide material. One exemplary high-k material is metal oxide (MOₓ). Examples include a metal oxide comprising predominantly aluminum (e.g., AlOₓ), a metal oxide comprising predominantly magnesium (e.g., MgO), a metal oxide comprising predominantly lanthanum (e.g., LaOₓ), a metal oxide comprising predominantly hafnium (e.g., HfOₓ) or predominantly zirconium (e.g., ZrOₓ). In other examples, the high-k material is an alloy metal oxide comprising significant portions of two or more metals (e.g., HfAlOₓ, or HfZrOₓ). In some further embodiments, the high-k material further includes silicon. For example, metal silicates, such as, but not limited to HfSiOₓ, HfAlSiOₓ, HfZrSiOₓ may also be suitable a gate insulator for some channel compositions (e.g., Si, Ge, SiGe, III-V). Some specific examples of other high-k materials include lanthanum aluminum oxide, zirconium oxide, zirconium silicon oxide, tantalum oxide, titanium oxide, barium strontium titanium oxide, barium titanium oxide, strontium titanium oxide, yttrium oxide, lead scandium tantalum oxide, and lead zinc niobate. Although the thickness of the high-k material may vary, in some exemplary embodiments it is no more than 2.0 nm, and may also be less than 1.0 nm.

In the example shown, fluorine is present within workfunction metal 217B, but substantially absent from workfunction metal 217A. In other embodiments, fluorine is present within both workfunction metals 217B and 217A, but the amount (concentration) of the fluorine is less in one or the other (e.g., less in workfunction metal 217A than in workfunction metal 217B). In the illustrated example, fluorine is in close proximity (e.g., with 1.0nm) of gate insulator 211 and may enter gate insulator 211. A close proximity of fluorine to channel region 115B may be advantageous for strongly affecting transistor Vₜ. Fluorine is however substantially absent from workfunction metal 217A that surrounds channel region 115A. As shown qualitatively in FIG. 3, the concentration of fluorine within workfunction metal 217B decreases from a detectable concentration C₂ to a concentration C₁ with greater proximity to channel region 115B. Fluorine concentration C₁ may be at, or below, a limit for detection associated with a given analysis technique, for example.

Fluorine may be introduced into a gate stack, for example, through plasma exposure or from a solid-state dopant source material. A fluorine source material may be sacrificial or retained within a RoW transistor stack as a permanent feature of a gate stack, for example as a gate fill or cap metal. Differing amounts of the fluorine may be introduced into various gate stacks of an IC die through a selective application and/or removal of a fluorine source material. Alternatively, or in addition, differing amounts of the flourine may be introduced into various gate stacks through the selective application and/or or removal of a diffusion barrier positioned between a source material and a workfunction metal.

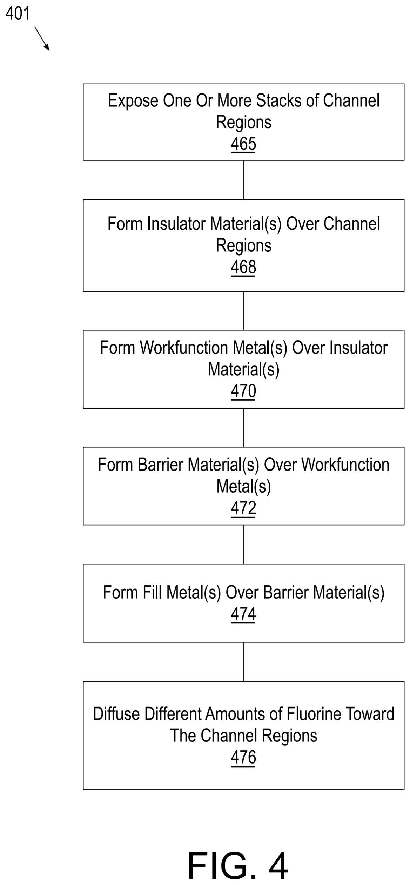

FIG. 4A is a flow diagram illustrating methods 401 for selective tuning of Vₜ within a RoW transistor stack, in accordance with some embodiments. Through the practice of methods 401, transistors within a single RoW transistor stack may be operative at different threshold voltages. Although the illustrated fluorine-based tuning may be combined with gate electrode workfunction tuning and/or dipole insulator tuning, in some embodiments a stacked transistor includes a single gate electrode workfunction metal and a single gate insulator material with different threshold voltages achieved exclusively through dipole tuning methods 401. Methods 401 may be practiced to arrive at RoW transistor stack structure 100, but may also be practiced to form other RoW transistor stack structures. Similarly, methods other than methods 401 may be practiced to arrive at RoW transistor stack structure 100.

Methods 401 begin at block 465 where a vertical stack of transistor channel regions are exposed. Within the vertical stack there are multiple transistor channel regions, one over the other. The vertical stack includes at least two channel regions and may include any integer number of channel regions (e.g., 3, 4, 5...10...20, etc.). The channel regions may comprise any channel material, such as Si, Ge, or SiGe, for example. The channel regions may advantageously all comprise substantially the same channel material. The channel regions may be suitable for two transistors. In some embodiments, the channels are suitable for a CMOS transistor stacked structure having transistors of complementary conductivity type within the stack.

Methods 401 continue at block 468 where one or more gate insulator materials are formed around different ones of the channel regions. In exemplary embodiments, the insulator material is a metallic compound that is suitable as a high-k insulator. Methods 401 continue at block 470 where one or more workfunction materials are formed over the various channel regions of the transistor stack. A first workfunction metal is deposited (e.g., by physical vapor deposition or chemical vapor deposition) over at least some channel regions within the stack structure. In further embodiments, block 470 also entails the deposition of a second workfunction metal (e.g., by physical vapor deposition or chemical vapor deposition). In some embodiments, fluorine is incorporated into at least one of the workfunction metals deposited at block 470, for example through exposure to a metal deposition precursor, or through exposure to a fluorine-based plasma prior to, concurrent with, or subsequent to, workfunction metal deposition. Such fluorination processes may be selective to only those transistors that are to receive a greater amount of fluorine. Alternatively, fluorine may be first incorporated into a material other than the workfunction metal subsequent to block 470 and then diffused from that material into the workfunction metal.

Methods 401 continue at block 472 where a barrier material is optionally deposited over the one or more workfunction metals. In some embodiments, formation of the barrier material is selective to those transistors where fluorine is to be limited. Deposition of the diffusion barrier may be with a PVD or CVD/ALD process where a metal such as Mo, W, Nb, Ta or Ti, is deposited along with a co-reactant comprising nitrogen to form a metal nitride (e.g., MoN, WN, TaN NbN, or TiN). Depending on the implementation, block 472 may be practiced in a manner that selectively varies a thickness of the deposited barrier material across different channel regions, for example as described further below.

At block 474 a gate stack is completed with the deposition of a gate electrode fill metal and/or cap metal over the workfunction metals (and over any barrier material, if present). The fill metal may be of any chemical composition, but is generally of a different composition than the underlying barrier and/or workfunction metals. For embodiments where the fill metal is to be a source of fluorine, the fill metal may be deposited by a technique that incorporates fluorine into the fill metal. In some exemplary embodiments, fill metal is deposited by CVD with a precursor gas that comprises fluorine (e.g., WF₆).

Methods 401 end at block 476 where different amounts of fluorine are diffused, for example from source material(s) toward various transistor channel regions. Block 476 may, for example, include a heat cycle during which transistor structures reach a temperature of over 500°C (e.g., 700°C, 750°C, 800°C, or 850°C) for a predetermined time in the presence of any suitable ambient, such as, but not limited to, nitrogen (N₂), or forming gas (N₂:H₂). At block 476 fluorine, for example incorporated within a gate electrode fill metal, may be driven in toward an underlying transistor channel region, and may come to rest within a workfunction metal to the extent diffusion is not limited by an intervening diffusion barrier material. Following the thermal drive-in of fluorine, a sacrificial fluorine source may be stripped, for example with a suitable chemical etch process. As noted above, removal of a fluorine source material is optional and it may instead by retained in the permanent transistor structure, for example as gate electrode fill metal.

Upon completion of methods 401, transistor structures may be interconnected with other transistor structures through one or more levels of interconnect metallization according to any backend of line (BEOL) fabrication processes known to be suitable for integrated circuits (ICs).

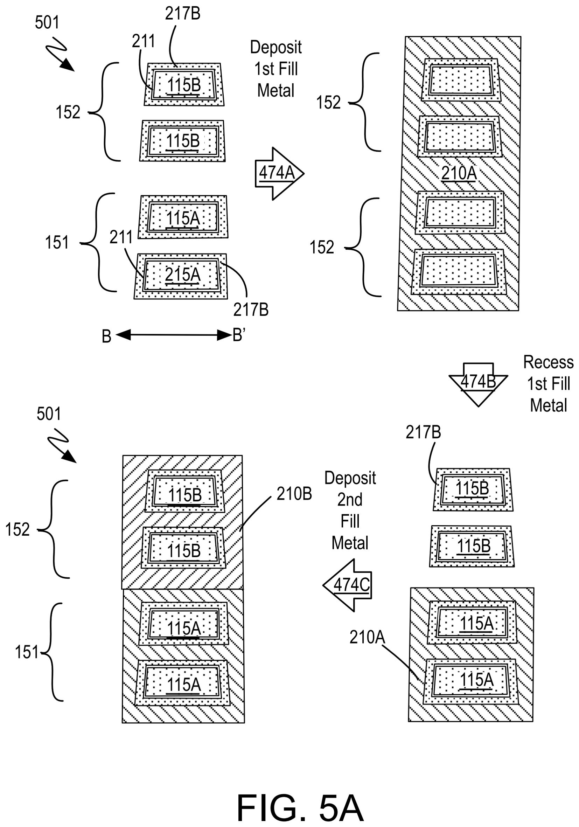

FIG. 5A illustrates a cross-sectional view of a RoW transistor stack structure 501 along the B-B' line introduced in FIG. 1A evolving as methods 401 are practiced in accordance with some embodiments where a fluorine source material is selectively formed around some channel regions of a stacked transistor structure. RoW transistor stack structure 501 shares many of the structural elements described above for RoW transistor structure 100. The reference numbers introduced in FIG. 1A, FIG. 2A and FIG. 2B are retained in FIG. 5A for structural features in RoW transistor stack structure 501 that have a direct analog in RoW transistor stack structure 100.

At operation 474A, a first gate electrode fill metal 210A is deposited around workfunction metals 217A and 217B. The fill metal deposition process may, for example, entail the use of a fluorine-based precursor. For example, a tungsten CVD process may utilize WF₆. Fill metal 210A is then planarized with RoW transistor stack structure 501, and then partially etched back at operation 474B to expose workfunction metal 217B around only the upper channel regions 115B (e.g., NMOS RoWs). At operation 474C, a second gate electrode fill metal 210B is deposited around workfunction metal 217B. The fill metal deposition process may lack any fluorine-based precursor. For example, a tungsten CVD process may utilize WCl₆ rather than WF₆. Fill metal 210B may then be planarized with RoW transistor stack structure 501 to arrive at a structure that may serve as the basis for selectively incorporating more fluorine into the gate stack of transistor 151 than that of transistor 152.

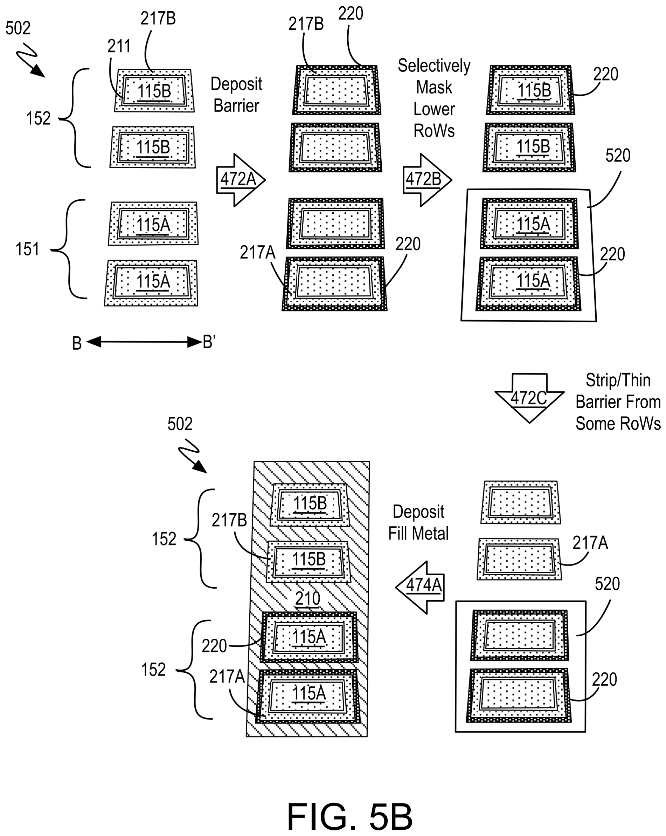

FIG. 5B illustrates a cross-sectional view of a RoW transistor stack structure 502 along the B-B' line introduced in FIG. 1A evolving as methods 401 are practiced in accordance with some alternative embodiments where a diffusion barrier thickness is modulated to differentiate fluorine doping across different transistor structures. RoW transistor stack structure 502 shares many of the structural elements described above for RoW transistor structure 100. The reference numbers introduced in FIG. 1A, FIG. 2A and FIG. 2B are retained in FIG. 5B for structural features in RoW transistor stack structure 502 that have a direct analog in RoW transistor stack structure 100.

At operation 472A diffusion barrier material 220 is deposited around workfunction metals 217A, 217B. Barrier material 220 may be any of the materials described above (e.g., MoN, TiN, etc.), for example. At operation 472B a selective masking process entails the deposition, planarization and partial etchback of a mask material 520. An etch process is then practiced at operation 472C to remove, or otherwise thin to some extent, the unmasked portion of barrier material 220 surrounding only channel regions 115B. Mask material 520 may then be removed and gate electrode fill metal 210 similarly deposited at operation 474A to arrive at structure that may serve as the basis for selectively incorporating more fluorine into the gate stack of transistor 152 than that of transistor 151. For example, a subsequent anneal can drive fluorine from fill metal 210 toward channel regions 115A and 115B with less fluorine diffusion reaching workfunction metal 217B because of the presence of barrier material 220. The absence (or a reduced non-zero thickness) of barrier material 220 in conjunction with the presence of fluorine within fill metal 210 is therefore indicative of a selective incorporation of fluorine into workfunction metal 217B.

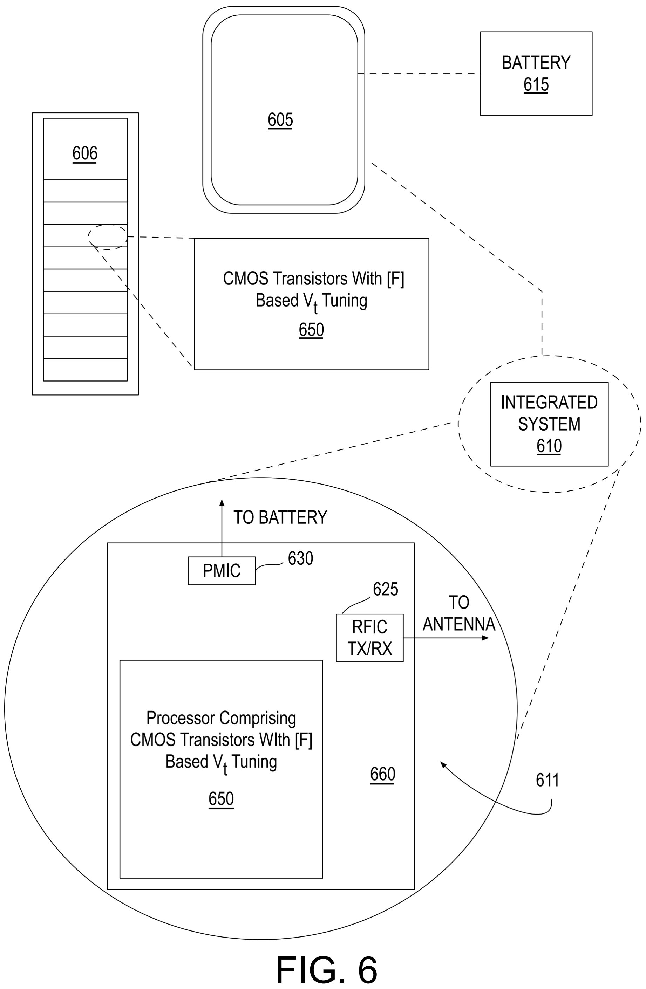

The RoW transistor structures with varying threshold voltages, and the methods of forming such structures described herein may be integrated into a wide variety of ICs and computing systems that include such ICs. FIG. 6 illustrates a system in which a mobile computing platform 605 and/or a data server machine 606 employs an IC having a memory and/or microprocessor IC with RoW transistor stack structures with fluorine-based threshold voltage tuning, for example in accordance with some embodiments described elsewhere herein. The server machine 606 may be any commercial server, for example including any number of high-performance computing platforms within a rack and networked together for electronic data processing, which in the exemplary embodiment includes a monolithic IC 650. The mobile computing platform 605 may be any portable device configured for each of electronic data display, electronic data processing, wireless electronic data transmission, or the like. For example, the mobile computing platform 605 may be any of a tablet, a smart phone, laptop computer, etc., and may include a display screen (e.g., a capacitive, inductive, resistive, or optical touchscreen), a chip-level integrated system 610, and a battery 615.

Whether disposed within the integrated system 610 illustrated in the expanded view 611, or as a stand-alone packaged chip within the server machine 606, IC 650 may include memory circuitry (e.g., RAM), and/or a logic circuitry (e.g., a microprocessor, a multi-core microprocessor, graphics processor, or the like). At least one of these circuitries further includes one or more RoW transistor stack structures fluorine-based threshold voltage tuning, for example in accordance with some embodiments described elsewhere herein. IC 650 may be further coupled to a board or package substrate 660 that further hosts one or more additional ICs, such as power management IC 630 and radio frequency IC 625. RFIC 625 may have an output coupled to an antenna 713 to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond.

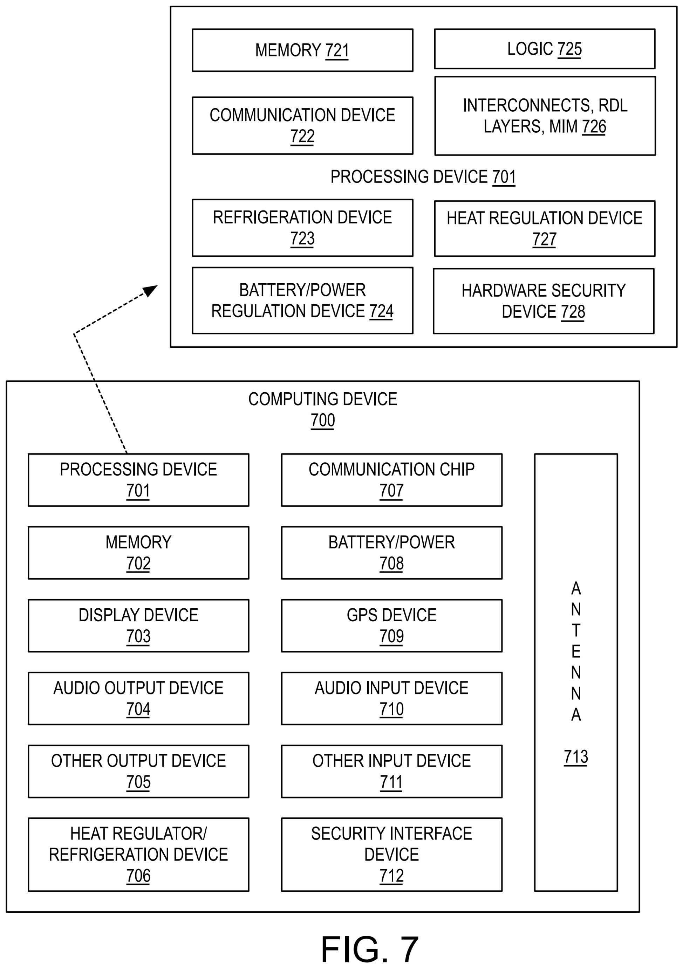

FIG. 7 is a block diagram of a cryogenically cooled computing device 700 in accordance with some embodiments. For example, one or more components of computing device 700 may include transistors with silicon source/drain semiconductor material that has been protected with an etch stop during silicon subfin removal and contacted with backside metallization, for example as described elsewhere herein. A number of components are illustrated in FIG. 13 as included in computing device 700, but any one or more of these components may be omitted or duplicated, as suitable for the application. In some embodiments, some or all of the components included in computing device 700 may be attached to one or more printed circuit boards (e.g., a motherboard). In some embodiments, various ones of these components may be fabricated onto a single system-on-a-chip (SoC) die. Additionally, in various embodiments, computing device 700 may not include one or more of the components illustrated in FIG. 7, but computing device 700 may include interface circuitry for coupling to the one or more components. For example, computing device 700 may not include a display device 703, but may include display device interface circuitry (e.g., a connector and driver circuitry) to which display device 703 may be coupled.

Computing device 700 may include a processing device 701 (e.g., one or more processing devices). As used herein, the term processing device or processor indicates a device that processes electronic data from registers and/or memory to transform that electronic data into other electronic data that may be stored in registers and/or memory. Processing device 701 may include a memory 721, a communication device 722, a refrigeration/active cooling device 723, a battery/power regulation device 724, logic 725, interconnects 726 (i.e., optionally including redistribution layers (RDL) or metal-insulator-metal (MIM) devices), a heat regulation device 727, and a hardware security device 728.

Processing device 701 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 701 may include a memory 702, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 721 includes memory that shares a die with processing device 701. This memory may be used as cache memory and may include embedded dynamic random-access memory (eDRAM) or spin transfer torque magnetic random-access memory (STT-M RAM).

Computing device 700 may include a heat regulation/refrigeration device 706. Heat regulation/refrigeration device 706 may maintain processing device 701 (and/or other components of computing device 700) at a predetermined low temperature during operation. This predetermined low temperature may be any temperature discussed elsewhere herein.

In some embodiments, computing device 700 may include a communication chip 707 (e.g., one or more communication chips). For example, the communication chip 707 may be configured for managing wireless communications for the transfer of data to and from computing device 700. The term "wireless" and its derivatives may be used to describe circuits, devices, systems, methods, techniques, communications channels, etc., that may communicate data through the use of modulated electromagnetic radiation through a nonsolid medium.

Communication chip 707 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). Communication chip 707 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 707 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 707 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 707 may operate in accordance with other wireless protocols in other embodiments. Computing device 700 may include an antenna 713 to facilitate wireless communications and/or to receive other wireless communications (such as AM or FM radio transmissions).

In some embodiments, communication chip 707 may manage wired communications, such as electrical, optical, or any other suitable communication protocols (e.g., the Ethernet). As noted above, communication chip 707 may include multiple communication chips. For instance, a first communication chip 707 may be dedicated to shorter-range wireless communications such as Wi-Fi or Bluetooth, and a second communication chip 707 may be dedicated to longer-range wireless communications such as GPS, EDGE, GPRS, CDMA, WiMAX, LTE, EV-DO, or others. In some embodiments, a first communication chip 707 may be dedicated to wireless communications, and a second communication chip 707 may be dedicated to wired communications.

Computing device 700 may include battery/power circuitry 708. Battery/power circuitry 708 may include one or more energy storage devices (e.g., batteries or capacitors) and/or circuitry for coupling components of computing device 700 to an energy source separate from computing device 700 (e.g., AC line power).

Computing device 700 may include a display device 703 (or corresponding interface circuitry, as discussed above). Display device 703 may include any visual indicators, such as a heads-up display, a computer monitor, a projector, a touchscreen display, a liquid crystal display (LCD), a light-emitting diode display, or a flat panel display, for example.

Computing device 700 may include an audio output device 704 (or corresponding interface circuitry, as discussed above). Audio output device 704 may include any device that generates an audible indicator, such as speakers, headsets, or earbuds, for example.

Computing device 700 may include an audio input device 710 (or corresponding interface circuitry, as discussed above). Audio input device 710 may include any device that generates a signal representative of a sound, such as microphones, microphone arrays, or digital instruments (e.g., instruments having a musical instrument digital interface (MIDI) output).

Computing device 700 may include a global positioning system (GPS) device 709 (or corresponding interface circuitry, as discussed above). GPS device 709 may be in communication with a satellite-based system and may receive a location of computing device 700, as known in the art.

Computing device 700 may include another output device 705 (or corresponding interface circuitry, as discussed above). Examples include an audio codec, a video codec, a printer, a wired or wireless transmitter for providing information to other devices, or an additional storage device.

Computing device 700 may include another input device 711 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 700 may include a security interface device 712. Security interface device 712 may include any device that provides security measures for computing device 700 such as intrusion detection, biometric validation, security encode or decode, managing access lists, malware detection, or spyware detection. In some examples, security interface device 712 comprises OTP ROM further including a via MIM fuse, for example as described elsewhere herein.

Computing device 700, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example the above embodiments may include specific combinations of features as further provided below.

In first examples, an integrated circuit (IC) structure comprises a first transistor, comprising a first channel region. The first channel region comprise at least one of Si or Ge. The first transistor comprises a first gate insulator layer over the first channel region, and a first gate electrode over the first gate insulator layer, wherein the first gate electrode has a first fluorine concentration. The IC structure comprises a second transistor comprising a second channel region. The second channel region comprise at least one of Si or Ge. The second transistor comprises a second gate insulator layer over the second channel region, and a second gate electrode over the second gate insulator layer. The second gate electrode has a second, different, fluorine concentration.

In second examples, for any of the first examples each of the first gate electrode and the second gate electrode comprises a workfunction metal and a fill metal. The workfunction metal of the first gate electrode has a higher concentration of fluorine than the workfunction metal of the second gate electrode.

In third examples, for any of the first through second examples first transistor has a first threshold voltage and the second transistor has a second threshold voltage.

In fourth examples, for any of the third examples the fill metal of the first gate electrode has a higher concentration of fluorine than the fill metal of the second gate electrode.

In fifth examples, for any of the fourth examples the fill metal of the first gate electrode comprises W, and the fill metal of the second gate electrode comprises W.

In sixth examples, for any of the third through fifth examples the workfunction metal of at least one of the first or second gate electrode comprises Al, Mo, W, or Ti.

In seventh examples, for any of the sixth examples, the first transistor and the second transistor are both NMOS transistors, the workfunction metal of the first gate electrode comprises Al, the workfunction metal of the second gate electrode comprises Al, and the first threshold voltage is higher than the second threshold voltage.

In eighth examples, for any of the second through seventh examples at least one of the first gate electrode and the second gate electrode comprises a barrier material layer between the workfunction metal and the fill metal. A barrier material layer of the first gate electrode is a first thickness A barrier material layer of the second gate electrode is a second thickness, and the first thickness is less than the second thickness.

In ninth examples, for any of the eighth examples the barrier material layer comprises a metal and nitrogen.

In tenth examples, for any of the ninth examples the barrier material layer comprises Mo, Nb, W or Ti.

In eleventh examples, for any of the eighth through tenth examples the workfunction metal has a thickness less than 0.5 nm, the first thickness of the barrier material layer is less than 1 nm, and the second thickness of the barrier material layer is greater than 1 nm.

In twelfth examples, for any of the first through eleventh examples the first transistor is an PMOS transistor, the second transistor is a NMOS transistor, the first gate electrode comprises a mid-gap workfunction metal in contact with the first gate insulator, wherein the mid-gap workfunction metal comprises the first fluorine concentration, and the second gate electrode comprises the mid-gap workfunction metal in contact with the second gate insulator, wherein the mid-gap workfunction metal has the second fluorine concentration.

In thirteenth examples, a transistor stack structure, comprises a first channel region over a second channel region. Each of the first channel region and the second channel region comprises at least one of Si or Ge. The transistor stack structure comprises a gate electrode around the first channel region, and around the second channel region. A first concentration of fluorine within a first portion of the gate electrode around the first channel is different from a second concentration of fluorine within a second portion of the gate electrode around the second channel. The transistor stack structure comprises a gate insulator material between the gate electrode and each of the first channel region and the second channel region, wherein the gate insulator material comprises oxygen and a first metal.

In fourteenth examples, for any of the thirteenth examples a first transistor comprises the first channel region and the first transistor has a first threshold voltage. A second transistor comprises the second channel region and the second transistor has a second threshold voltage, different than the first threshold voltage. The first portion of gate electrode comprises a workfunction metal with the first concentration of fluorine, and the second portion of the gate electrode comprises a workfunction metal with the second concentration of fluorine.

In fifteenth examples, for any of the thirteenth through fourteenth examples the transistor stack structure further comprises a first source material coupled to a first drain material through the first channel region. The first source material and the first drain material are of a first conductivity type. The transistor stack structure comprises second source material coupled to a second drain material through the second channel region, wherein the second source material and the second drain material are of a second conductivity type, complementary to the first conductivity type.

In sixteenth examples, for any of the fifteenth examples the first conductivity type is P-type, and the second conductivity type is N-type, and the first portion of the gate electrode comprises the same workfunction metal and the second portion of the gate electrode.

In seventeenth examples, for any of the thirteenth through sixteenth examples the transistor stack structure further comprises a barrier material. The gate insulator material is between the barrier material and at least one of the first channel region or the second channel, and the barrier material comprises Mo, Nb, Ti or W.

In eighteenth examples, a method of fabricating transistor stack comprises forming a gate insulator around a first channel region and around a second channel region. The first and the second channel regions comprise at least one of Si or Ge. The method comprises forming a gate electrode around the gate insulator. Forming the gate electrode comprises depositing a metal with a precursor gas comprising fluorine. The method comprises diffusing a first amount of fluorine toward the first channel region, and diffusing a second amount of fluorine, different than the first amount, toward second channel region.

In nineteenth examples, for any of the eighteenth examples depositing a metal with a precursor gas comprising fluorine comprises depositing W over a workfunction metal of the gate electrode.

In twentieth examples, for any of the nineteenth examples the diffusing further comprises performing a thermal anneal at a temperature of at least 700 °C.

However, the above embodiments are not limited in this regard and, in various implementations, the above embodiments may include the undertaking of only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An integrated circuit (IC) structure, comprising:
a first transistor, comprising:
a first channel region, wherein the first channel region comprise at least one of Si or Ge;
a first gate insulator layer over the first channel region; and
a first gate electrode over the first gate insulator layer, wherein the first gate electrode has a first fluorine concentration; and
a second transistor comprising:
a second channel region, wherein the second channel region comprise at least one of Si or Ge;
a second gate insulator layer over the second channel region; and
a second gate electrode over the second gate insulator layer, wherein the second gate electrode has a second, different, fluorine concentration.

2. The IC structure of claim 1, wherein:
each of the first gate electrode and the second gate electrode comprises a workfunction metal and a fill metal; and
the workfunction metal of the first gate electrode has a higher concentration of fluorine than the workfunction metal of the second gate electrode.

3. The IC structure of claim 2, wherein the first transistor has a first threshold voltage and the second transistor has a second threshold voltage.

4. The IC structure of claim 3, wherein the fill metal of the first gate electrode has a higher concentration of fluorine than the fill metal of the second gate electrode.

5. The IC structure of claim 4, wherein:
the fill metal of the first gate electrode comprises W; and
the fill metal of the second gate electrode comprises W.

6. The IC structure of one of the previous claims, wherein the workfunction metal of at least one of the first or second gate electrode comprises Al, Mo, W, or Ti.

7. The IC structure of claim 6, wherein:
the first transistor and the second transistor are both NMOS transistors;
the workfunction metal of the first gate electrode comprises Al;
the workfunction metal of the second gate electrode comprises Al; and
the first threshold voltage is higher than the second threshold voltage.

8. The IC structure of one of the previous claims, wherein:
at least one of the first gate electrode and the second gate electrode comprises a barrier material layer between the workfunction metal and the fill metal;
a barrier material layer of the first gate electrode is a first thickness;
a barrier material layer of the second gate electrode is a second thickness; and
the first thickness is less than the second thickness.

9. The IC structure of claim 8, wherein the barrier material layer comprises a metal and nitrogen.

10. The IC structure of claim 9, wherein the barrier material layer comprises Mo, Nb, W or Ti.

11. The IC structure of claim 8, 9 or 10, wherein:
the workfunction metal has a thickness less than 0.5 nm;
the first thickness of the barrier material layer is less than 1 nm; and
the second thickness of the barrier material layer is greater than 1 nm.

12. The IC structure of one of the previous claims, wherein:
the first transistor is an PMOS transistor;
the second transistor is a NMOS transistor;
the first gate electrode comprises a mid-gap workfunction metal in contact with the first gate insulator, wherein the mid-gap workfunction metal comprises the first fluorine concentration; and
the second gate electrode comprises the mid-gap workfunction metal in contact with the second gate insulator, wherein the mid-gap workfunction metal has the second fluorine concentration.

13. A transistor stack structure, comprising:
a first channel region over a second channel region, wherein each of the first channel region and the second channel region comprises at least one of Si or Ge;
a gate electrode around the first channel region, and around the second channel region, wherein a first concentration of fluorine within a first portion of the gate electrode around the first channel is different from a second concentration of fluorine within a second portion of the gate electrode around the second channel; and
a gate insulator material between the gate electrode and each of the first channel region and the second channel region, wherein the gate insulator material comprises oxygen and a first metal.

14. The transistor stack structure of claim 13, wherein:
a first transistor comprises the first channel region and the first transistor has a first threshold voltage;
a second transistor comprises the second channel region and the second transistor has a second threshold voltage, different than the first threshold voltage;
the first portion of gate electrode comprises a workfunction metal with the first concentration of fluorine; and
the second portion of the gate electrode comprises a workfunction metal with the second concentration of fluorine.

15. The transistor stack structure of claim 13 or 14, further comprising:
a first source material coupled to a first drain material through the first channel region, wherein the first source material and the first drain material are of a first conductivity type; and
a second source material coupled to a second drain material through the second channel region, wherein the second source material and the second drain material are of a second conductivity type, complementary to the first conductivity type.
